# EUROPEAN PATENT SPECIFICATION

(11) **EP 1 065 730 B1**
(45) Date of publication and mention of the grant of the patent: **29.11.2006**
(21) Application number: 99900329.6
(22) Date of filing: 18.01.1999
(51) Int. Cl.: H01L 29/74

(54) **COMPRESSION CONTACTED SEMICONDUCTOR DEVICE**
UNTER DRUCK KONTAKTIERTES HALBLEITERBAUELEMENT
DISPOSITIF A SEMICONDUCTEUR CONTACTÉ PAR COMPRESSION

(43) Date of publication of application: 03.01.2001
(73) Proprietor: MITSUBISHI DENKI KABUSHIKI KAISHA, Chiyoda-ku Tokyo 100-8310 (JP)
(72) Inventor: KAWAMURA, Toshinobu, Mitsubischi Denki K.K., Tokyo 100-8310 (JP); SATOH, Katsumi, Mitsubishi Denki K.K., Tokyo 100-8310 (JP)
(74) Representative: Sajda, Wolf E.
(86) International application number: PCT/JP1999/000120
(87) International publication number: WO 2000/042664

(56) References cited:
- DE-A- 2 705 476
- JP-A- 10 270 475
- JP-U- 62 032 555
- US-A- 5 777 351

## Description

### TECHNICAL FIELD

The present invention relates to a compression-contact type semiconductor device for use in an electric power converter apparatus such as a GCT (Gate Commutated Turn-Off) thyristor.

In particular, the invention relates to a compression-contact type semiconductor device as specified in the preamble of claim 1. Such a semiconductor device is known from US-A-5 777 351 disclosing a previous development of the applicant.

### BACKGROUND OF THE INVENTION

While a GTO (Gate Turn-Off) thyristor has been widely used so far as a device applicable to a large capacity power electronics, it requires a snubber circuit and it has been difficult to suppress the increase of snubber loss which occurs due to the increase of its operating voltage. However, a GCT (Gate Commutated Turn-Off) thyristor (hereinafter referred to simply as a GCT) from which the snubber circuit is eliminated has realized a performance of 6,000 A of maximum breaking current and of 3 *µ*s or less of turn-off storage time, thus accelerating the further increase of capacity and speed.

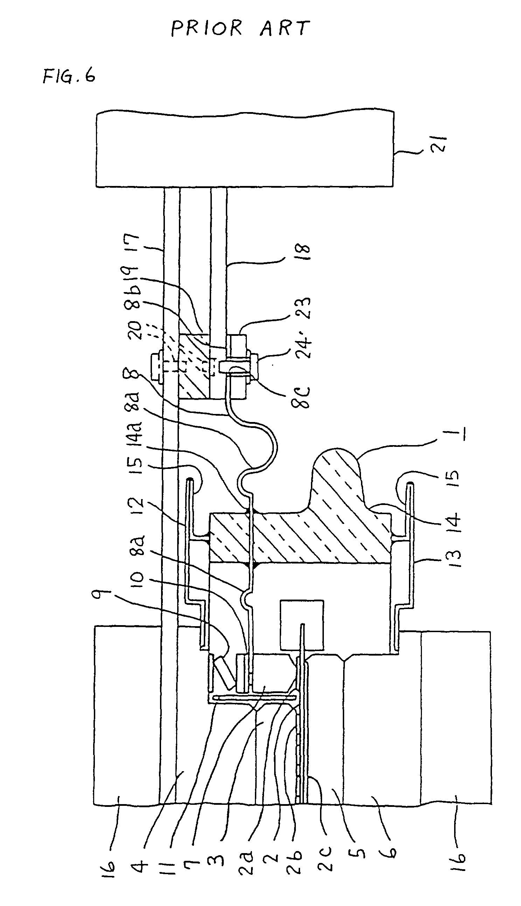

FIG. 6 is a section view showing the structure of a prior art compression-contact type semiconductor device described in JP-A- 8-330572 for example as a system including the GCT and a gate drive device for controlling the GCT. In the figure, the reference numeral (1) denotes the GCT and (2) a semiconductor substrate. A gate electrode 2a made of aluminum is formed at the outer peripheral part on the surface of the semiconductor substrate 2, a cathode electrode 2b is formed inside thereof and an anode electrode 2c is formed on the back of the substrate. The reference numerals (3 and 4) denote a cathode distortion buffer disk and an external cathode electrode mounted one after another on the surface of the semiconductor substrate 2 at the cathode electrode 2b side, (5 and 6) an anode distortion buffer disk and an external anode electrode mounted one after another at the anode electrode 2c side, (7) a ring gate electrode made of molybdenum which abuts to the gate electrode 2a of the semiconductor substrate 2, (8) a ring-shaped external gate terminal made of iron or nickel alloy whose inner peripheral part abuts to the ring gate electrode 7 and whose outer peripheral part projects out of the side of an insulating cylinder 14 described later. It has curved portions 8a at the inside and outside of the insulating cylinder 14 and a predetermined number (24 in the GCT of 6 kV/6 kA of rate for example) of attachment holes 8c formed at concentric equal parts in a portion 8b connected with a plate-shaped control gate electrode 18 described later. The reference numeral (9) denotes an elastic body which presses the ring gate electrode 7 to the gate electrode 2a together with the external gate electrode 8 via an annular insulator 10, (11) an insulator, (12) a first flange secured to the external cathode electrode 4, (13) a second flange secured to the external anode electrode 6 and (14) the insulating cylinder which is divided into upper and lower parts. The outer peripheral part of the external gate terminal 8 projects out of the side of the insulating cylinder 14 and is secured thereto by soldering at a divider section 14a. Each end 15 secured to the insulating cylinder 14 is secured to the first and second flanges 12 and 13, thus sealing the GCT 1.

The reference numeral (16) denotes a stack electrode for pressing the GCT 1 and taking out current and for radiating heat from the external cathode electrode 4 and the external anode electrode 6 at the same time, (17) a plate-shaped control electrode made of an annular metal plate disposed concentrically with the external gate terminal 8, (18) a plate-shaped control gate electrode made of an annular metal plate which is disposed concentrically with the external gate terminal 8 and whose inner peripheral part is electrically connected with the outer peripheral part of the external gate terminal 8 and (19) an insulation sleeve for insulating the plate-shaped control electrode 17 from the plate-shaped control gate electrode 18. It is fixed to the plate-shaped control electrode 17 and the plate-shaped control gate electrode 18 by a fastener 20. The plate-shaped control electrode 17 and the plate-shaped control gate electrode 18 are both connected to a gate drive device 21 for controlling the GCT 1. The reference numeral (23) denotes a holding plate such as a washer which plays a role of a distortion correcting plate for maintaining the adherence of the outer peripheral part of the external gate terminal 8 with the inner peripheral part of the plate-shaped control gate electrode 18, by fixing the connection portion 8b of the outer peripheral part of the external gate terminal 8 and the inner peripheral part of the plate-shaped control gate electrode 18 by a fastener 24 per each attachment hole 8c. The connection portions 8b are provided in a GCT of 6 kV/4 kA of rate (its outer diameter is about 147 mm) and 24 connection portions are provided in a GCT of 6 kV/6 kA of rate (its outer diameter is about 200 mm) for example.

Next, the operation of the GCT 1 will be explained. The GCT 1 may be turned on by igniting main current flowing from the external anode electrode 6 to the external cathode electrode 4 by isotropically supplying gate current from the whole circumferential plane from the gate drive device 21 to the external gate terminal 8 of the GCT 1. It may be also turned off by instantly extinguishing the main current by supplying gate current in the reverse direction from that of turn-on. A current transient fall inclination of the gate current at the time of turn-off is about 6,000 A/µs, thus enabling the increase of switching speed together with a transient rise inclination of about 1,000 A/µs at the time of turn-on.

The prior art GCT 1 has been constructed as described above and has had the following problems.

The increase of capacity of the GCT has inevitably promoted the increase of an aperture of the semiconductor substrate 2 and the aperture of the package as well as the increase of the maximum breaking current has increased a number of segments concentrically connected in parallel on the surface of the semiconductor substrate 2. The larger the outer diameter, the more the number of attachment holes 8c for connecting with the plate-shaped control gate electrode 18 connected to the gate drive device 21 increase at the outer peripheral part of the external gate terminal 8 pulled to the outside from the side of the insulating cylinder 14. Then, when a number of the gate drive devices 21 is limited, outgoing inspection of the GCT 1 cannot but be done by repeatedly replacing the GCT 1. Thus, there has been a problem that it takes much labor and time in works for attaching/removing the fastener 24 for fixing the attachment portion 8b. For instance, at least three times of works of attaching and removing 24 of such fasteners 24 have been required in the outgoing inspection of the GCT 1 of 6 kV/6 kA of rate (turn-on test and turn-off test by means of pulse test in high or low temperature). Much more labor and time is required for such works when the capacity of the GCT 1 increases.

Further, although the holding plate 23 plays the role of the distortion correction plate for holding the adhesion of the outer peripheral part of the external gate terminal 8 with the inner peripheral part of the plate-shaped control gate electrode 18, pressure in the vicinity of the fixing section of the fastener 24 is liable to increase when the thickness of the holding plate 23 is relatively thin. At this time, the outer peripheral part of the external gate terminal 8 adheres with the inner peripheral part of the plate-shaped control gate electrode 18 at the connection portion 8b only in the vicinity of the fixing section of the fastener 24 like a point-to-point contact. Therefore, there has been a problem that the original ability of supplying uniform gate current to the external gate terminal 8, i.e., the feature of the GCT 1, may not be fully exhibited and the GCT 1 might be permanently destroyed as current concentrates locally.

While the increase of the switching speed of the GCT 1 has increased the use in the application of control of large current in the operating frequency range exceeding 1 kHz for example, fluctuation of flux induced by repeated phase inversion of the gate current induces an inductive heating effect due to the electromagnetic induction, thus increasing the temperature of the external gate terminal 8, when the material of the external gate terminal 8 is ferro-magnetic material such as iron or nickel. Further, because it is difficult to directly cool the external gate terminal 8 due to the shape and disposition of the parts regardless of the material of the external gate terminal 8, the increase of capacity due to the increase of the maximum breaking current of the GCT 1 inevitably invites the increase of temperature due to the heat of the gate electrode 2a. Because the gate electrode 2a provided at the end of the semiconductor substrate 2 is not fully cooled in contrary to the cathode electrode 2b and the anode electrode 2c which are effectively cooled, there has been a problem that the in-plane temperature distribution of the semiconductor substrate 2 becomes non-uniform, thus changing the characteristics of the GCT 1.

Accordingly, the present invention has been devised to solve the above-mentioned problems and its object is to provide a compression bonded type semiconductor device which can simplify the works for attaching/removing the GCT to/from the gate drive device.

Another object is to provide a compression bonded type semiconductor device which is capable of preventing the outer peripheral part of the external gate terminal from contacting with the inner peripheral part of the plate-shaped control gate electrode at the connection portion like a point-to-point contact.

A still other object is to provide a compression bonded type semiconductor device which is capable of suppressing the in-plane temperature distribution of the semiconductor substrate of the GCT from becoming non-uniform.

### DISCLOSURE OF THE INVENTION

According to the invention, there is provided a compression bonded type semiconductor element having a semiconductor substrate wherein a gate electrode and a cathode electrode are formed on the surface thereof and an anode electrode is formed on the back thereof, an insulating cylinder containing the semiconductor substrate, a ring gate electrode which abuts to the gate electrode and an external gate terminal whose outer peripheral part projects out of the side of the insulating cylinder and is secured to the insulating cylinder and whose inner peripheral part abuts to the ring gate electrode. There is also provided a control gate electrode which can be connected to an external controller electrically connected with the external gate terminal. Then, there is provided a support member disposed concentrically with the external gate terminal and having an elastic body which presses a connection section where the external gate terminal is electrically connected with the plate-shaped control gate electrode. A stack electrode compresses the compression bonded type semiconductor element and supports the support member. Because the support member presses the external gate terminal to the plate-shaped control gate electrode when there is provided the support member disposed concentrically with the external gate terminal and having an elastic body which presses the connection section where the external gate terminal is electrically connected with the plate-shaped control gate electrode and the stack electrode compresses the compression bonded type semiconductor element and supports the support member, attachment holes and fasteners for fixing the external gate terminal to the plate-shaped control gate electrode may be eliminated. Therefore, it becomes possible to simplify works for attaching or removing the GCT to/from the plate-shaped control gate electrode.

According to the invention, the elastic body may be formed into a ringed-shape. The connection section of the outer peripheral part of the external gate terminal and the inner peripheral part of the plate-shaped control gate electrode may be pressed uniformly when the elastic body is formed into the ringed shape. Therefore, it becomes possible to prevent the contact at the connection section from becoming like a point-to-point contact and to eliminate the possibility of permanent destruction of the GCT as current concentrates locally.

According to the invention, there may be provided a heat release mechanism in the support member. Because the heat of the gate electrode section may be cooled via the ring gate electrode and the external gate electrode when the heat release mechanism is provided in the support member, it becomes possible to suppress the in-plane temperature distribution of the semiconductor substrate of the GCT from becoming non-uniform.

Still more, according to the invention, the heat release mechanism may be a water cooling type mechanism. When the heat release mechanism is the water cooling type, the heat of the gate electrode section may be cooled efficiently via the ring gate electrode and the external gate electrode. Therefore, it becomes possible to suppress the in-plane temperature distribution of the GCT from becoming non-uniform.

Further, according to the invention, there is provided a compression bonded type semiconductor element having a disc-shaped semiconductor substrate wherein a gate electrode is formed on the outer peripheral part of the surface thereof, a cathode electrode is formed inside of the gate electrode and an anode electrode is formed on the back thereof, an external cathode electrode disposed so as to be able to press the cathode electrode, an external anode electrode disposed so as to be able to press the anode electrode, an insulating cylinder containing the semiconductor substrate, an annular ring gate electrode which abuts to the gate electrode and an external gate terminal made of an annular plate which projects out of the side of the insulating cylinder and is secured to the insulating cylinder and whose inner peripheral part abuts to the ring gate electrode. There are also provided a plate-shaped control electrode disposed concentrically with the external gate terminal and is electrically connected with the external cathode electrode, a plate-shaped control gate electrode disposed concentrically with the external gate terminal and is electrically connected with the external gate terminal at the inner peripheral part thereof and a gate drive device for controlling gate current to which the plate-shaped control electrode and the plate-shaped control gate electrode are fixed via a first insulator to connect with the plate-shaped control electrode and the plate-shaped control gate electrode. There are also provided a stack electrode composed of a first stack electrode for compressing the compression bonded type semiconductor element from the external cathode electrode and a second stack electrode which compresses the compression bonded type semiconductor element from the external anode electrode and which extends below a connection section where the external gate terminal is electrically connected with the plate-shaped control gate electrode. Then, there is provided a support member disposed concentrically with the external gate terminal between the connection section where the external gate terminal is electrically connected with the plate-shaped control gate electrode and the second stack electrode and having an annular elastic body which presses the connection section and a second insulator for electrically insulating the second stack electrode and the external gate terminal. Because the support member presses the external gate terminal to the plate-shaped control gate electrode when there is provided the support member disposed concentrically with the external gate terminal between the connection section where the external gate terminal is electrically connected with the plate-shaped control gate electrode and the second stack electrode and having the annular elastic body which presses the connection section and the second insulator for electrically insulating the second stack electrode which extends below the connection section and the external gate terminal, the attachment holes and fasteners for fixing the external gate terminal to the plate-shaped control gate electrode may be eliminated. Therefore, it becomes possible to simplify works for attaching/removing the GCT to/from the plate-shaped control gate electrode. Further, because the elastic body is formed into the ringed shape, it becomes possible to press uniformly the connection section of the outer peripheral part of the external gate terminal with the inner peripheral part of the plate-shaped control gate electrode. Therefore, it becomes possible to prevent the contact of the connection section from becoming like a point-to-point contact.

### BRIEF DESCRIPTION OF THE DRAWINGS

FIG. 1 is a section view showing the structure of a compression bonded type semiconductor device according to a first mode of the present invention.
FIGs. 2A, 2B and 2C are section views showing the structure of the main part of a compression bonded type semiconductor device according to a modified example of the first mode.
FIG. 3 is a section view showing the structure of the main part of a compression bonded type semiconductor device according to another modified example of the first mode.
FIG. 4 is a perspective view showing the partially-cut-away structure of a compression bonded type semiconductor device according to a second mode of the present invention.
FIGs. 5A, B, C and D are section views showing the main part of a compression bonded type semiconductor device according to a modified example of the second mode.
FIG. 6 is a section view showing the structure of a prior art compression bonded type semiconductor device.

### BEST MODE FOR CARRYING OUT THE INVENTION

The present invention will be explained in detail with reference to the accompanying drawings.

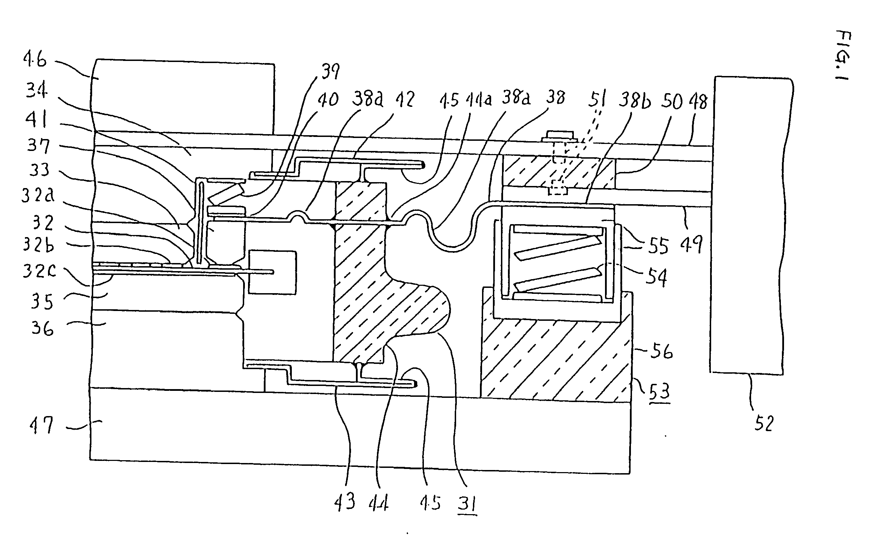

FIG. 1 is a section view showing the structure of a compression bonded type semiconductor device according to a first mode of the present invention. It is a section view showing the structure of the compression bonded type semiconductor device as a system including a gate drive device for controlling a compression bonded type semiconductor device such as GCT into the GCT. In FIG. 1, the reference numeral (31) denotes the GCT and (32) a disk semiconductor device. A gate electrode 32a made of aluminum is formed at the outer peripheral part, on the surface of the semiconductor substrate 32, a cathode electrode 32b made of aluminum is formed inside the gate electrode 32a and an anode electrode 32c made of aluminum is formed on the back of the gate electrode 32a.

The reference numerals (33 and 34) denote a cathode distortion buffer disk made of molybdenum and an external cathode electrode made of copper mounted one after another on the surface of the semiconductor substrate 32 at the cathode electrode 32b side, (35 and 36) an anode distortion buffer disk made of molybdenum and an external anode electrode made of copper mounted one after another at the anode electrode 32c side, (37) a ring gate electrode made mainly of copper, molybdenum, stainless steel or the like which abuts against the gate electrode 32a of the semiconductor substrate 32, (38) an external gate terminal made of non-magnetic ring-shaped plate mainly made of materials which is not affected to electromagnetic induction such as copper, molybdenum, tungsten or their alloy such as phosphor bronze. Its inner peripheral part abuts to the ring gate electrode 37 and whose outer peripheral part projects out of the side of an insulating cylinder 44 described later. It has curved portions 38a at the inside and outside of the insulating cylinder 34 and is connected to a plate-shaped control gate electrode 49 described later at a connection section 38b. The reference numeral (39) denotes an elastic body such as a disc spring or wave spring which presses the ring gate electrode 37 to the gate electrode 32a together with the external gate electrode 38 via an annular insulator 40, (41) an insulator made of an insulating sheet such as polyimide and provided between the ring gate electrode 37, the external gate terminal 38 and the external cathode electrode 34. (42) a first flange made of iron, nickel or the like which is secured to the external cathode electrode 34, (43) a second flange made of iron, nickel or the like which is secured to the external anode electrode 36 and (44) the insulating cylinder which is made of ceramics or the like and is divided into upper and lower parts. The outer peripheral part of the external gate terminal 38 projects out of the side of the insulating cylinder 44 and is secured thereto at a divider section 44a. Each end 45 secured to the insulating cylinder 44 is secured to the first and second flanges 42 and 43, thus sealing the GCT 31.

The reference numeral (46) denotes a first stack electrode for pressing the GCT 31 from the external cathode electrode 34, (47) a second stack electrode for pressing the GCT 31 from the external anode electrode 36 side and extending below the connection portion 38b where the external gate terminal 38 is electrically connected with a plate-shaped control gate electrode 49 described later. The stack electrodes composed of the first stack electrode 46 and the second stack electrode 47 press the GCT 31, take out current and radiate heat from the external cathode electrode 34 and the external anode electrode 36. The reference numeral (48) denotes the plate-shaped control electrode made of a ringed metal plate disposed concentrically with the external gate terminal 38 and pressed to the external cathode electrode 34 by the first stack electrode 46, (49) a plate-shaped control gate electrode made of a ringed metal plate which is disposed concentrically with the external gate terminal 38 and whose inner peripheral part is electrically connected with the outer peripheral part of the external gate terminal 38 and (50) an insulation sleeve for insulating the plate-shaped control electrode 48 from the plate-shaped control gate electrode 49. It is fixed to the plate-shaped control electrode 48 and the plate-shaped control gate electrode 49 by a fastener 51 such as a bolt. The plate-shaped control electrode 48 and the plate-shaped control gate electrode 49 are both connected to a gate drive device 52 for controlling the GCT 31.

The reference numeral (53) denotes a ringed support member which is disposed concentrically with the external gate terminal 38 between the connection section 38b where the external gate terminal 38 and the plate-shaped control gate electrode 49 are electrically connected and the second stack electrode 47 and which presses the connection section 38b. This support member 53 contains an elastic body 54 formed into a ring by a disc spring or wave spring and is composed of a ringed gate terminal holding plate 55 made of metal pressing the connection section 38b and a ringed second insulator 56 provided between the second stack electrode 47 and the gate terminal holding plate 55 to electrically insulate the second stack electrode 47 from the gate terminal holding plate 55.

Next, the operation thereof will be explained. The GCT 31 may be turned on by igniting main current flowing from the external anode electrode 36 to the external cathode electrode 34 by isotropically supplying gate current from the whole circumferential plane from the gate drive device 52 to the external gate terminal 38 of the GCT 31. It may be also turned off by instantly extinguishing the main current by supplying gate current in the reverse direction from that of turn-on. A current transient fall inclination of the gate current at the time of turn-off is about 6,000 A/µs, thus enabling the increase of switching speed together with a transient rise inclination of about 1,000 A/µs at the time of turn-on. The contact at the connection section 38b connecting the external gate terminal 38 with the plate-shaped control gate electrode 49 which forms a part of a feeding path from the external cathode electrode 34 to the plate-shaped control gate electrode 49 must be fully done in order to feed the large current instantly at the time of turn-on or turn-off as described above.

According to the first mode, the second stack electrode 47 is extended below the connection section 38b where the external gate terminal 38 is electrically connected with the plate-shaped control gate electrode 49 and there is provided the support member 53 having the second elastic body 54 which is disposed concentrically with the external gate terminal 38 between the connection section 38b where the external gate terminal 38 and the plate-shaped control gate electrode 49 are electrically connected and the second stack electrode 47 to press the connection section 38b. By constructing as described above, the members provided to fix the external gate terminal 8 to the plate-shaped control gate electrode 18 in the prior art GCT of 6 kV/6kA of rate for example, i.e., 24 attachment holes 8c, the holding plate 23 and the fastener 24, may be eliminated because the support member 53 presses the connection section 38b. Therefore, it becomes possible to attach/remove the GCT simply to/from the plate-shaped control gate electrode.

Further, the second elastic body 54 is formed into a ringed shape. Thereby, the connection section 38b of the outer peripheral part of the external gate terminal 38 and the inner peripheral part of the plate-shaped control gate electrode 49 may be pressed uniformly, thus preventing the contact of the connection section 38b from becoming point-to-point contact and eliminating the possibility of permanent destruction of the GCT which is otherwise caused as current concentrates locally.

Further, it becomes possible to suppress the external gate terminal 38 from abnormally generating heat as it is affected by electromagnetic induction locally by the magnetic field of the external circuit in operating in high frequency by adopting a non-magnetic member as the member of the external gate terminal 38.

It is noted that the positional relationship between the gate holding plate 55 containing an elastic body 54 and the second insulator 56 may be up side down and may bring about the same effect.

Further, the first stack electrode 46 may be extended to the connection section 38b similarly to the second stack electrode 47. It also brings about the same effect as described above.

Still more, the gate drive device may be an external control unit so long as it controls the gate current. A control gate electrode which can be connected to the external control unit may have a shape other than the plate-shape.

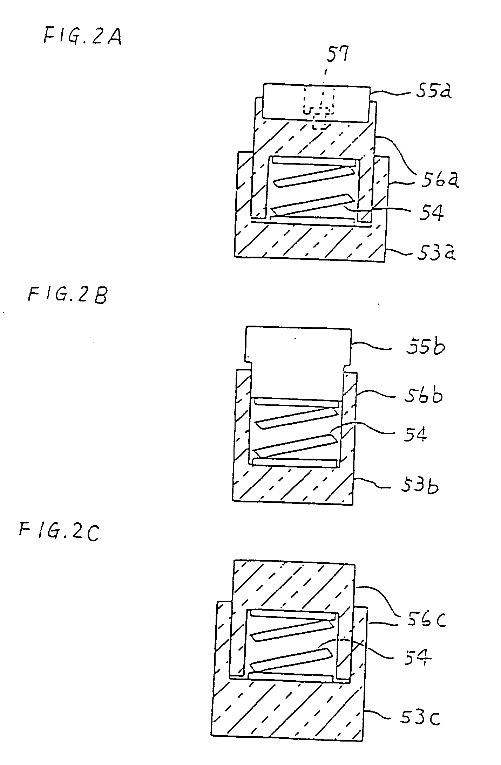

A modified example of the support member 53 will be explained next in FIGs. 2A, 2B and 2C. In FIG. 2A, the reference numeral (53a) denotes a ringed support member disposed concentrically with the external gate terminal 38 between the connection section 38b and the second stack electrode 47 to press the connection section 38b. The support member 53a is composed of a ringed gate terminal holding plate 55a made of metal which abuts to the external gate terminal 38 and a ringed second insulator 56a which contains a second elastic body 54 for electrically insulating the second stack electrode 47 from the gate terminal holding plate 55a and brings about the same effect as described above. It is noted that the second insulator 56a is constructed so as to include the second elastic body 54 from the external gate terminal 38 side and the second stack electrode 47 side. Its end on the external gate terminal 38 side is fixed to the gate terminal holding plate 55a by a bolt 57 and presses the connection section 38b by the urging force of the second elastic body 54. In FIG. 2B, the reference numeral (53b) denotes a ringed support member disposed concentrically with the external gate terminal 38 between the connection section 38b and the second stack electrode 47 to press the connection section 38b. The support member 53b is composed of a ringed gate terminal holding plate 55b made of metal which abuts to the external gate terminal 38 and a ringed second insulator 56b which contains a second elastic body 54, is provided between the second stack electrode 47 and the gate terminal holding plate 55b to electrically insulate the second stack electrode 47 from the gate terminal holding plate 55b and brings about the same effect as described above. In FIG. 2C, the reference numeral (53c) denotes a ringed support member disposed concentrically with the external gate terminal 38 between the connection section 38b and the second stack electrode 47 to press the connection section 38b. The support member 53c is composed of a ringed second insulator 56c made of an insulator which contains the second elastic body 54 and is provided between the connection section 38b and the second stack electrode 46 to electrically insulate the second stack electrode 47 from the external gate terminal 38. It also brings about the same effect with what described above.

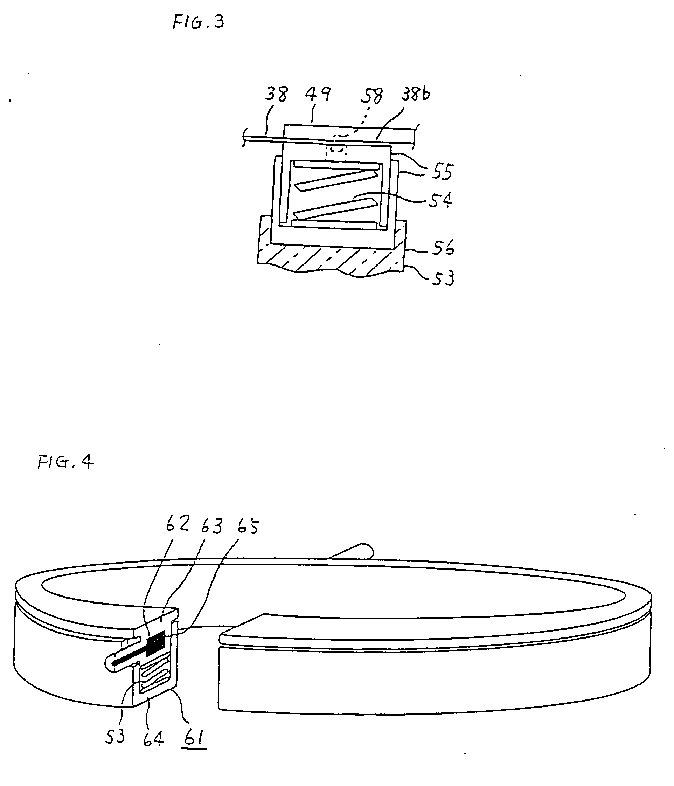

Further, six bolts 58 at most may be attached from the gate terminal holding plate 55 side in order to improve the contact of the connection section 38b between the external gate terminal 38 and a plate-shaped control gate electrode 49 as shown in FIG. 3.

It is noted that the gate electrode 32a has been formed at the outer peripheral part on the surface of the semiconductor substrate 32 as one example of the gate structure of the GCT 31 of the first embodiment, the gate electrode may be formed at the middle section of the surface. It also brings about the same effect.

Next, a compression bonded type semiconductor device of a second mode of the invention will be explained by using FIG. 4.

FIG. 4 is a perspective view showing the partially-cut-away structure of the compression bonded type semiconductor device according to the second mode of the invention. What is different in FIG. 4 from those in FIG. 1 is that a heat release mechanism is provided in the support member. That is, the reference numeral (61) denotes a ringed support member disposed concentrically with the external gate terminal 38 between the connection section 38b where the external gate terminal 38 is electrically connected with the plate-shaped control gate electrode 48 and the second stack electrode 47 to press the connection section 38b. This support member 61 comprises a ringed gate terminal holding plate 63 formed of metal which abuts to the plate-shaped control gate electrode 48, e.g., metal on which soft metal is coated on oxygen free copper, and having a heat release mechanism 62, a second ringed elastic body 54 made of a disc spring or wave spring and a second insulator 64 containing the second elastic body 54 and provided between the second stack electrode 47 and the gate terminal holding plate 63 to electrically insulate the second stack electrode 47 from the gate terminal holding plate 63. The heat release mechanism 62 is constructed by circulating coolant water within a ringed water passage 65 provided within the gate terminal holding plate 63.

According to the second mode, the heat release mechanism 62 is provided in the support member 61. Such structure allows heat of the gate electrode 32a section to be cooled by the heat release mechanism 62 via the ring gate electrode 37 and the external gate terminal 38. Therefore, it becomes possible to suppress the in-plane temperature distribution of the semiconductor substrate 32 of the GCT 31 from becoming non-uniform.

The water cooling type heat release mechanism is adopted. Such structure also allows the heat of the gate electrode 32a section to be cooled efficiently by the heat release mechanism 62 via the ring gate electrode 37 and the external gate terminal 38. Therefore, it becomes possible to suppress the in-plane temperature distribution of the semiconductor substrate 32 of the GCT 31 from becoming non-uniform.

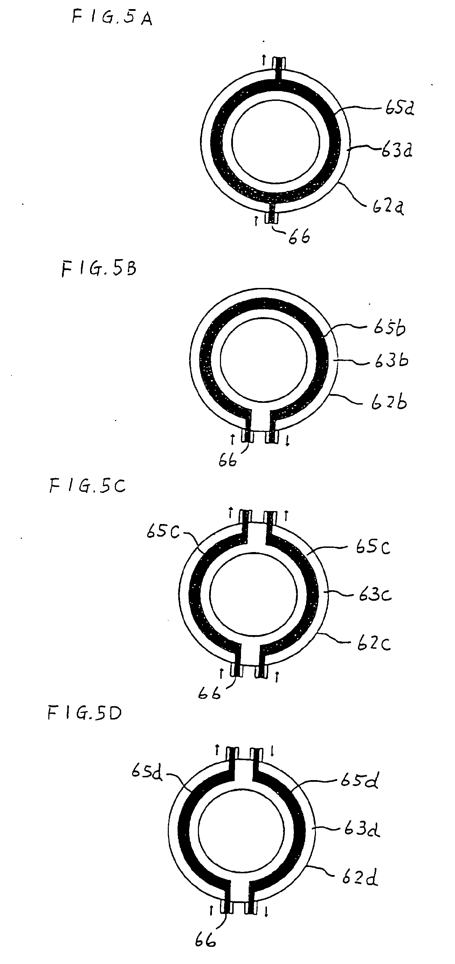

A modified example of the heat release mechanism 62 will be also explained next with reference to FIGs. 5A, 5B, 5C and 5D. In FIG. 5A, a heat release mechanism 62a is constructed so that there is one each inlet and outlet of coolant water 66, the water flow of the coolant water 66 is divided into two directions at the inlet and the water flows within a water passage 65 provided in the gate terminal holding plate 63a and is combined again at the outlet. In FIG. 5B, a heat release mechanism 62b is constructed so that there is one each inlet and outlet of coolant water 66 and the water flow of the coolant water 66 flows so as to circulate within a water passage 65b provided in a gate terminal holding plate 63b. In FIG. 5C, a heat release mechanism 62c is constructed so that there are two each inlet and outlet of coolant water 66 and the water flow of the coolant water 66 flows so as to circulate partially within water passages 65c provided in a gate terminal holding plate 63c in the same direction from each other. In FIG. 5D, a heat release mechanism 62d is constructed so that there are two each inlet and outlet of coolant water 66 and the water flow of the coolant water 66 flows so as to circulate partially within water passages 65d provided in a gate terminal holding plate 63d in the opposite direction from each other. The heat release mechanisms in FIGs. 5A, 5B, 5C and 5D also bring about the same effects as in second mode.

### INDUSTRIAL APPLICABILITY

As described above, the inventive compression bonded type semiconductor device is suitable for quickly turning on/off large current of the main circuit by the gate control. For instance, it is suitable for BTB (Bus Tie Breaker) and SVG (Static Var Generator) as an application to electric power, for driving a large capacity inverter for paper or steel making rolling mill as an application to industrial use, for a ground transformer station as an application to rail railways and for a high voltage large capacity switch, etc.

## Claims

1. A compression-contact type semiconductor device, comprising
- a compression-contact type semiconductor element having a semiconductor substrate (32) wherein a gate electrode (32a) and a cathode electrode (32b) are formed on the surface thereof and an anode electrode (32c) is formed on the back thereof, an insulating cylinder (44) containing the semiconductor substrate (32), a ring gate electrode (37) which abuts to the gate electrode (32a) and a ring external gate terminal (38) whose outer peripheral part projects out of the side of the insulating cylinder (44) and is secured to the insulating cylinder (44) and whose inner peripheral part abuts to the ring gate electrode (37);
- a control gate electrode (49) which can be connected to an external controller electrically connected with the external gate terminal (38); and
- a support member (53) supporting the external gate terminal (38),
**characterized in that** the support member (53) is disposed concentrically with the external gate terminal (38) and has an elastic body (54) which presses against a connection section (38b) where the external gate terminal (38) is electrically connected with the control gate electrode (49);
and **in that** a first stack electrode (46) and a second stack electrode (47) are provided for compressing the compression-contact type semiconductor element and for supporting the support member (53),
wherein the first stack electrode (46) is positioned on one major surface side of the semiconductor element, and the second stack electrode (47) is positioned on the other major surface side of the semiconductor substrate (32) and extends below the connection section (38b) thereby supporting the support member (53).

2. The device according to claim 1,
**characterized in that** the elastic body (54) is formed into a ring-shape.

3. The device according to claim 1 or 2,
**characterized in that** a heat release mechanism (62) is provided in the support member (53).

4. The device according to claim 3,
**characterized in that** the heat release mechanism (62) is a water cooling type mechanism.

5. The device according to any of claims 1 to 4,
**characterized in that** the gate electrode (32a) is formed on the outer peripheral part of the surface of the semiconductor substrate (32) and the cathode electrode (32b) is formed inside of the gate electrode (32a),
**in that** an external cathode electrode (34) is disposed so as to be able to press against the cathode electrode (32b), and an external anode electrode (36) is disposed so as to be able to press against the anode electrode (32c),
**in that** a plate-shaped control electrode (48) is disposed concentrically with the external gate terminal (38) and is electrically connected with the external cathode electrode (34),
**in that** the control gate electrode (49) is plate-shaped and disposed concentrically with the external gate terminal (38) and is electrically connected with the external gate terminal (38) at the inner peripheral part thereof and a gate drive device (52) for controlling a gate current, to which the plate-shaped control electrode (48) and the plate-shaped control gate electrode (49) are fixed via a first insulator (50) to connect with the plate-shaped control electrode (48) and the plate-shaped control gate electrode (49),
**in that** the first stack electrode (46) is provided for compressing the semiconductor element from the external cathode electrode (34), and the second stack electrode (47) is provided for compressing from the external anode electrode (36), which extends below the connection section (38b) where the external gate terminal (38) is electrically connected with the plate-shaped control gate electrode (49),
and **in that** the support member (53) comprises a second insulator (56) for electrically insulating the second stack electrode (47) and the external gate terminal (38).

## Patentansprüche

1. Druckkontakt-Halbleitervorrichtung, die folgendes aufweist:
- ein Druckkontakt-Halbleiterelement mit einem Halbleitersubstrat (32), wobei eine Gateelektrode (32a) und eine Kathodenelektrode (32b) auf seiner Oberfläche gebildet sind und eine Anodenelektrode (32c) auf seiner Rückseite gebildet ist, mit einem isolierenden Zylinder (44), der das Halbleitersubstrat (23) enthält, mit einer ringförmigen Gateelektrode (37), die an der Gateelektrode (32a) anliegt, und mit einem äußeren ringförmigen Gateanschluß (38), dessen Außenumfangsbereich von der Seite des isolierenden Zylinders (44) nach außen ragt und an dem isolierenden Zylinder (44) befestigt ist und dessen Innenumfangsbereich an der ringförmigen Gateelektrode (37) anliegt;
- eine Steuergateelektrode (49), die mit einer externen Steuerung verbunden werden kann, die mit dem externen Gateanschluß (38) elektrisch verbunden ist; und
- ein Abstützelement (53), das den externen Gateanschluß abstützt,
**dadurch gekennzeichnet,**
**daß** das Abstützelement (53) in bezug auf den externen Gateanschluß (38) konzentrisch angeordnet ist und einen elastischen Körper (54) aufweist, der gegen einen Verbindungsbereich (38b) drückt, an dem der externe Gateanschluß (38) mit der Steuergateelektrode (49) elektrisch verbunden ist;
und **daß** eine erste Stapelelektrode (46) und eine zweite Stapelelektrode (47) vorgesehen sind, um das Druckkontakt-Halbleiterelement zusammenzudrücken und das Abstützelement (53) abzustützen,
wobei die erste Stapelelektrode (46) auf der Seite der einen Hauptfläche des Halbleiterelements angeordnet ist und die zweite Stapelelektrode (47) auf der Seite der anderen Hauptfläche des Halbleitersubstrats (32) angeordnet ist und sich unterhalb des Verbindungsbereiches (38b) erstreckt und dadurch das Abstützelement (53) abstützt.

2. Vorrichtung nach Anspruch 1,
**dadurch gekennzeichnet,**
**daß** der elastische Körper (54) ringförmig ausgebildet ist.

3. Vorrichtung nach Anspruch 1 oder 2,
**dadurch gekennzeichnet,**
**daß** ein Wärmeabgabemechanismus (62) in dem Abstützelement (53) vorgesehen ist.

4. Vorrichtung nach Anspruch 3,
**dadurch gekennzeichnet,**
**daß** der Wärmeabgabemechanismus (62) ein Mechanismus vom Typ mit Wasserkühlung ist.

5. Vorrichtung nach einem der Ansprüche 1 bis 4,
**dadurch gekennzeichnet,**
**daß** die Gateelektrode (32a) an dem Außenumfangsbereich der Oberfläche des Halbleitersubstrats (32) ausgebildet ist und die Kathodenelektrode (32b) innenseitig von der Gateelektrode (32a) ausgebildet ist,
**daß** eine externe Kathodenelektrode (34) derart angeordnet ist, daß sie gegen die Kathodenelektrode (32b) drücken kann, und eine externe Anodenelektrode (36) derart angeordnet ist, daß sie gegen die Anodenelektrode (32c) drücken kann,
**daß** eine plattenförmige Steuerelektrode (48) konzentrisch zu dem externen Gateanschluß (38) angeordnet ist und mit der externen Kathodenelektrode (34) elektrisch verbunden ist,
**daß** die Steuergateelektrode (49) plattenförmig ausgebildet ist und konzentrisch zu dem externen Gateanschluß (38) angeordnet ist und mit dem externen Gateanschluß (38) an dem Innenumfangsbereich von diesem elektrisch verbunden ist sowie mit einer Gateansteuereinrichtung (52) zum Steuern eines Gatestroms elektrisch verbunden ist, an der die plattenförmige Steuerelektrode (48) und die plattenförmige Steuergateelektrode (49) über einen ersten Isolator (50) angebracht sind, um eine Verbindung mit der plattenförmigen Steuerelektrode (48) und der plattenförmigen Steuergateelektrode (49) herzustellen,
**daß** die erste Stapelektrode (46) dafür vorgesehen ist, das Halbleiterelement von der externen Kathodenelektrode (34) her zusammenzudrücken und die zweite Stapelelektrode (47) dafür vorgesehen ist, dieses von der externen Anodenelektrode (36) her zusammenzudrücken, die sich unterhalb des Verbindungsbereiches (38b) erstreckt, an dem der externe Gateanschluß (38) mit der plattenförmigen Steuergateelektrode (49) elektrisch verbunden ist,
und **daß** das Abstützelement (53) einen zweiten Isolator (56) aufweist, um die zweite Stapelelektrode (47) und den externen Gateanschluß elektrisch zu isolieren.

## Revendications

1. Dispositif semi-conducteur du type à contact par compression, comprenant:
-- un élément semi-conducteur du type à contact par compression ayant un substrat semi-conducteur (32) dans lequel sont formées une électrode de gâchette (32a) et une électrode de cathode (32b) sur la surface de celui-ci, et une électrode d'anode (32c) est formée sur l'envers de celui-ci, un cylindre isolant (44) contenant le substrat semi-conducteur (32), une électrode de gâchette annulaire (37) qui est en butée avec l'électrode de gâchette (32a) et une borne de gâchette externe annulaire (38) dont la partie périphérique extérieure se projette hors du côté du cylindre isolant (44) et est fixée au cylindre isolant (44) et dont la partie périphérique intérieure est en butée avec l'électrode de gâchette annulaire (37);
-- une électrode de portillon de commande (49) qui peut être connectée à un contrôleur externe qui est électriquement connecté avec la borne de gâchette externe (38); et
-- un élément de support (53) qui supporte la borne de gâchette externe (38),
**caractérisé en ce que** l'élément de support (53) est disposé concentriquement avec la borne de gâchette externe (38) et comporte un corps élastique (54) qui presse contre un tronçon de connexion (38b) auquel la borne de gâchette externe (38) est connectée électriquement avec l'électrode de portillon de commande (49);
et **en ce qu'**il est prévu une première électrode empilée (46) et une seconde électrode empilée (47) pour comprimer l'élément conducteur du type à contact par compression et pour supporter l'élément de support (53),
dans lequel la première électrode empilée (46) est positionnée sur un côté de surface principale de l'élément semi-conducteur, et la seconde électrode empilée (47) est positionnée sur l'autre côté de surface principale du substrat mi-conducteur (32) et s'étend au-dessous du tronçon de connexion (38b), supportant ainsi l'élément de support (53).

2. Dispositif selon la revendication 1,
**caractérisé en ce que** le corps élastique (54) est formé sous une forme annulaire.

3. Dispositif selon la revendication 1 ou 2,
**caractérisé en ce qu'**un mécanisme de dégagement thermique (62) est prévu dans l'élément de support (53).

4. Dispositif selon la revendication 3,
**caractérisé en ce que** le mécanisme de dégagement thermique (62) est un mécanisme du type à refroidissement par eau.

5. Dispositif selon l'une quelconque des revendications 1 à 4,
**caractérisé en ce que** l'électrode de gâchette (32a) est formée sur la partie périphérique extérieure de la surface du substrat semi-conducteur (32) et l'électrode de cathode (32b) est formée à l'intérieur de l'électrode de gâchette (32a),
**en ce qu'**une électrode de cathode externe (34) est disposée de manière à être capable de presser contre l'électrode de cathode (32b), et une électrode d'anode externe (36) est disposée de manière à être capable de presser contre l'électrode d'anode (32c),
**en ce qu'**une électrode de commande (48) en forme de plaque est disposée concentriquement avec la borne de gâchette externe (38) et est connectée électriquement avec l'électrode de cathode externe (34),
**en ce que** l'électrode de gâchette de commande (49) est en forme de plaque et disposée concentriquement avec la borne de gâchette externe (38) et est connectée électriquement avec la borne de gâchette externe (38) au niveau de la partie périphérique intérieure de celle-ci, et un dispositif de pilotage de gâchette (52) pour commander un courant de gâchette, et sur lequel l'électrode de commande en forme de plaques (48) et l'électrode de gâchette de commande en forme de plaque (49) sont fixées via un premier isolateur (50) pour être connectées avec l'électrode de commande (48) en forme de plaque et avec l'électrode de gâchette de commande (49) en forme de plaque,
**en ce que** la première électrode empilée (46) est prévue pour comprimer l'élément semi-conducteur depuis l'électrode de cathode externe (34), et la seconde électrode empilée (47) est prévue pour être comprimée depuis l'électrode d'anode externe (36), qui s'étend au-dessous du tronçon de connexion (38b) où la borne de gâchette externe (38) est connectée électriquement avec l'électrode de gâchette de commande (49) en forme de plaque,
et **en ce que** l'élément de support (53) comprend un second isolateur (56) pour isoler électriquement la seconde électrode empilée (47) et la borne de gâchette externe (38).
